Europäisches Patentamt

European Patent Office

Office européen des brevets

(11) Veröffentlichungsnummer: **0 585 836 A2**

# EUROPÄISCHE PATENTANMELDUNG

(21) Anmeldenummer: 93113735.0

(51) Int. Cl.⁵: **G03F 7/16**

(22) Anmeldetag: **27.08.93**

(30) Priorität: **02.09.92 DE 4229244**

(43) Veröffentlichungstag der Anmeldung:
**09.03.94 Patentblatt 94/10**

(84) Benannte Vertragsstaaten:
**AT BE CH DE ES FR GB IT LI NL SE**

(71) Anmelder: **BASF Aktiengesellschaft**
**Carl-Bosch-Strasse 38**
**D-67063 Ludwigshafen(DE)**

(72) Erfinder: **Hoessel, Peter, Dr.**
**Salierstrasse 71**
**D-6707 Schifferstadt(DE)**
Erfinder: **Stephan, Oskar**
**Kolpingstrasse 1**
**D-6832 Hockenheim(DE)**
Erfinder: **Hoffmann, Gerhard, dr.**
**Pappelstrasse 22**
**D-6701 Otterstadt(DE)**
Erfinder: **Langen, Juergen, Dr.**
**Am Herrengarten 65**
**D-5300 Bonn 3(DE)**

(54) **Verfahren zur Herstellung von Mikrostrukturkörpern.**

(57) Die Erfindung betrifft ein Verfahren zur Herstellung von Mikrostrukturkörpern mit Strukturtiefen von mehreren μm bis in den mm-Bereich durch bildmäßiges Bestrahlen von Polymeren mit Röntgenstrahlen und Entfernen der bildmäßig bestrahlten Bereiche der Polymeren, wobei die Polymeren vor dem bildmäßigen Bestrahlen in Schichtdicken von mehreren μm bis in den mm-Bereich durch Aufschmelzen in einem Rahmen mit einem Preßstempel unter Druck auf einen elektrisch leitfähigen Träger aufgebracht und fest verankert werden.

Das erfindungsgemäße Verfahren eignet sich insbesondere zur Herstellung von Mikrostrukturkörpern mit Strukturtiefen zwischen 3 μm und 2000 μm und kleinsten lateralen Abmessungen von unter 10 μm.

FIG.1

Die Erfindung betrifft ein Verfahren zur Herstellung von Mikrostrukturkörpern mit Strukturtiefen von mehreren μm bis in den mm-Bereich durch bildmäßiges Bestrahlen von Polymeren mit Röntgenstrahlen und Entfernen der bildmäßig bestrahlten Bereiche der Polymeren, wobei diese Polymeren vor dem bildmäßigen Bestrahlen unter Druck auf einem elektrisch leitfähigen Träger fest verankert werden.

Die Entwicklung der Mikroelektronik hat gezeigt, daß die konsequente Miniaturisierung und Integration zu einer unüberschaubaren Vielfalt neuer Produkte mit entsprechenden Technologien führt. Die Mikroelektronik hat in wenigen Jahren gegenüber anderen Industriezweigen einen gewaltigen Vorsprung in der Miniaturisierung gewonnen. Inzwischen zeichnet sich ab, daß in Zukunft auch andere Mikrotechniken eine große Bedeutung erlangen werden, wobei insbesondere die Mikromechanik und die integrierte Optik zu erwähnen sind. Solche Techniken eröffnen in der Kombination mit der Mikroelektronik eine unvorstellbare Zahl neuer elektronischer, optischer, biologischer und mechanischer Funktionselemente.

Bei einer Massenfertigung von nichtelektronischen Bauelementen, Systemkomponenten und Subsystemen der Mikrotechnik wird man naturgemäß die außerordentlich leistungsfähigen Fertigungsmethoden der Halbleitertechnik in möglichst großem Umfang nutzen. Gleichzeitig muß man versuchen, klassische Methoden der Feinwerktechnik für die Mikromechanik zu ertüchtigen und mit entsprechend modifizierten Halbleiterfertigungsmethoden zu verschmelzen, um so die engen Grenzen der Siliciumplanartechnik verlassen und neue Gestaltungsmöglichkeiten erschließen zu können, die auf einer Vielfalt von Formen und Materialien aufbauen. Diese Forderung wird z.B. in hohem Maße durch das LIGA-Verfahren erfüllt, das auf den Fertigungsschritten

- Lithographie,
- Galvanoformung und
- Abformung

aufgebaut und am Kernforschungszentrum Karlsruhe (KfK) entwickelt worden ist.

Interessante Mikrostrukturprodukte sind Sensoren zur Messung von Beschleunigung, Durchfluß, Ultraschall, Feuchte u.ä., Mikromotoren, mikropneumatische Bauelemente, Mikrostecker für die Mikroelektronik, mikrooptische Bauelemente, Faseroptiken, Mikroelektroden, Spinndüsen, Mikrofilter, Gleitlager, Membrane und vieles mehr.

Der wesentliche Fertigungsschritt des LIGA-Verfahrens ist die strukturgenaue Bestrahlung des eingesetzten Polymeren. Die prinzipielle Durchführbarkeit des LIGA-Verfahrens konnte anhand einfacher Mikrostrukturen mit einem speziell hergestellten Polymethylmethacrylat (im folgenden PMMA genannt) nachgewiesen werden.

Für die Herstellung komplexer dreidimensionaler Strukturen mit Strukturtiefen von mehreren μm bis in den mm-Bereich nach dem oben genannten LIGA-Verfahren, muß das PMMA auf eine leitfähige Trägerplatte aufgebracht werden. Bisher wird hierfür ein spezielles Gießverfahren verwendet. Hierbei wird in Methylmethacrylat gelöstes PMMA als Gießharz verwendet, und mit speziellen Initiatoren, Katalysatoren und Haftvermittlern in einem Rahmen in flüssiger Form auf die elektrisch leitfähige Trägerplatte aufgebracht und unter dem Einfluß von Licht oder Temperatur polymerisiert.

Durch die Verarbeitung eines Gießharzes ergeben sich die folgenden Probleme:

a) der durch die Polymerisation des Gießharzes auf der Trägerplatte erzeugte Polymerisationsschrumpf führt zu Spannungen im Laminat;

b) um diese Spannungen weitgehend zu vermeiden, müssen lange Temperprozesse bei der Polymerisation und Abkühlzeiten bis zu 24 Stunden in Kauf genommen werden;

c) die Auswahlmöglichkeit an Polymeren ist beschränkt. Es können nur Polymere, welche als Gießharze oder in Form ihrer Monomere während des Laminierprozesses polymerisierbar sind, verwendet werden;

d) es können keine beliebigen, kommerziell erhältlichen Thermoplaste in beliebiger fester Form, z.B. als Granulat oder Pulver verwendet werden;

e) bislang werden nur PMMA nach dem oben beschriebenen Verfahren für das LIGA-Verfahren eingesetzt.

Bei der Herstellung komplexer dreidimensionaler Strukturen mit Strukturtiefen von mehreren μm bis in den mm-Bereich nach dem oben genannten LIGA-Verfahren hat sich gezeigt, daß PMMA einen hohen Bestrahlungsaufwand erfordert.

Weiter hat sich gezeigt, daß bei der Entwicklung der bestrahlten Polymeranteile mit einem geeigneten Entwicklermedium die unbestrahlten Polymeranteile quellen, wobei feine Mikrostrukturen zerstört werden können. Andererseits können gequollene Polymeranteile beim Austrocknen zu Spannungsrissen führen, die bei der Galvanik zu unbrauchbaren Mikrostrukturkörpern führen. Ursache für diese Probleme ist die hohe Lösungsmittelempfindlichkeit des PMMA.

Aufgabe der vorliegenden Erfindung ist es, ein Verfahren aufzuzeigen, das die Lösung der oben angeführten Probleme ermöglicht. Nach dem neuen Verfahren sollten mit beliebigen Polymeren, insbesondere solchen, wie sie in den deutschen Patentanmeldungen DE-A-41 07 662, DE-A-41 07 851 und DE-A-41 41 352 beschrieben werden, zu einem dauerhaften Polymer/Träger-Verbund verarbeitet werden können. Eine weitere Aufgabe der vorliegenden Erfindung bestand darin, ein Verfahren zu entwickeln, das es erlaubt, diesen Polymer/Trägerverbund in möglichst kurzer Zeit, d.h. in wenigen Stunden oder gar in Minuten exakt und reproduzierbar herzustellen, wobei auch eine hohe Genauigkeit der gewünschten Polymerschichtdicke über die gesamte Resistfläche und ein fehlerfreier Aufbau auch innerhalb der Polymerschicht erreicht werden sollte.

Überraschenderweise lassen sich diese Aufgaben durch ein Preßverfahren unter Verwendung eines Preßstempels innerhalb eines Rahmens, der die Abmessungen der Polymerschicht vorgibt, lösen.

Gegenstand der vorliegenden Erfindung ist ein Verfahren zur Herstellung von Mikrostrukturkörpern mit Strukturtiefen von mehreren $\mu$m bis in den mm-Bereich durch bildmäßiges Bestrahlen von Polymeren mit Röntgenstrahlen und Entfernen der bildmäßig bestrahlten Bereiche der Polymeren, das dadurch gekennzeichnet ist, daß die Polymeren vor dem bildmäßigen Bestrahlen in Schichtdicken von mehreren $\mu$m bis in den mm-Bereich durch Aufschmelzen in einem Rahmen unter Druck mit einem Preßstempel auf einen elektrisch leitfähigen Träger aufgebracht und fest verankert werden.

Als Polymere für das erfindungsgemäße Verfahren können vorzugsweise sowohl amorphe Thermoplaste als auch teilkristalline Thermoplaste eingesetzt werden, die jeweils während des Preßverfahrens aufgeschmolzen werden.

Als Röntgenstrahlen zum bildmäßigen Bestrahlen wird vorzugsweise Synchrotronstrahlung eingesetzt.

Das erfindungsgemäße Verfahren eignet sich insbesondere zur Herstellung von Mikrostrukturkörpern mit Strukturtiefen zwischen 3 $\mu$m und 2000 $\mu$m und kleinsten lateralen Abmessungen von unter 10 $\mu$m.

Zum erfindungsgemäßen Verfahren ist im einzelnen folgendes auszuführen.

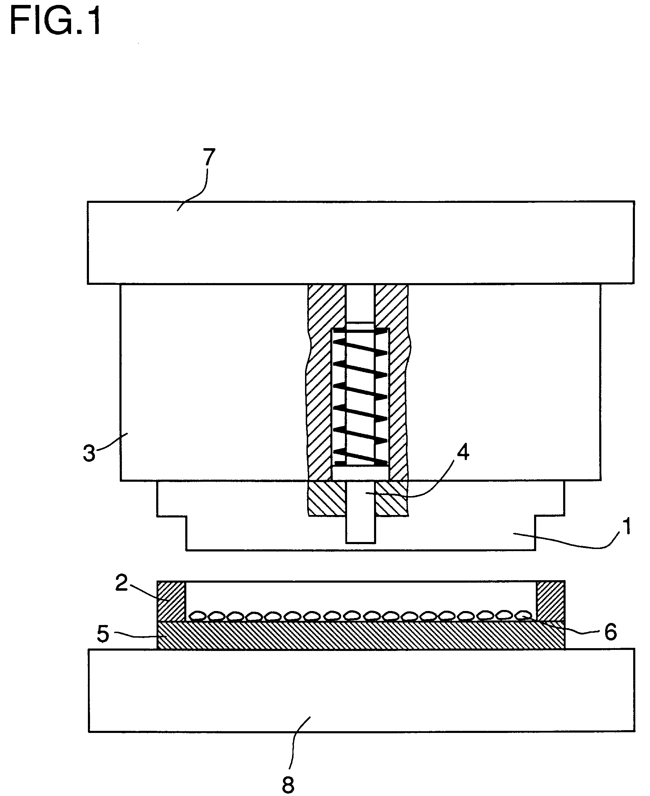

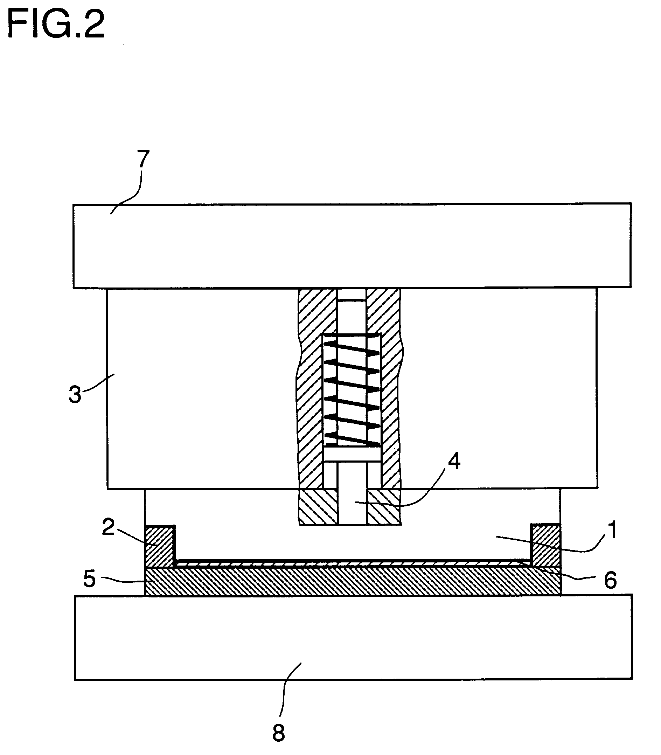

Im allgemeinen werden Schichtdicken von 3 bis 2000 $\mu$m benötigt. Bevorzugt sind Schichtdikken von 50 bis 650 $\mu$m,
Als Preßwerkzeug kann beispielsweise die in Fig. 1 (= Preßwerkzeug im geöffneten Zustand) bzw. Fig. 2 (= Preßwerkzeug im geschlossenen Zustand) schematisch gezeigte Kombination aus einem Preßstempel (1) und einem Rahmen (2) dienen. Als Material für das Preßwerkzeug wird vorzugsweise Metall, z.B. Stahl, verwendet. Das Preßwerkzeug befindet sich zwischen einem Pressenoberteil (7) und einem Pressenunterteil (8).

Der Preßstempel (1) ist zweckmäßigerweise mit Schrauben an einen festen Metallblock (3) fixiert. In diesem Metallblock befinden sich mehrere, im allgemeinen mindestens 4 Bolzen (4), welche mit Hilfe einer Federkraft vor dem eigentlichen Preßvorgang den Rahmen auf die Grundplatte (5) aufpressen.

Die Unterseite des Preßstempels (1) ist poliert oder geläppt und besitzt Oberflächenrauhigkeiten unter 200 nm.

Die Differenz in der Höhe des Rahmens (2) und des Preßstempels 1 bestimmt die Schichtdicke des Polymers (6) auf der elektrisch leitfähigen Grundplatte. Im allgemeinen werden Schichtdicken von bis zu 2000 $\mu$m benötigt. Besonders bevorzugt sind Schichtdicken von 50 bis 650 $\mu$m.

Der Rahmen (2) kann vorzugsweise mit einer Halterung auf eine gleich große Grundplatte (5) fixiert werden oder aber während des Preßvorgangs fest mit der Grundplatte verbunden werden, z.B. durch Anschrauben oder Niederhalter. Um ein Unterwandern des Polymers während des Preßvorganges zwischen Rahmen und Grundplatte zu vermeiden, ist die Unterseite des Rahmens poliert oder geläppt und besitzt eine Oberflächenrauhigkeit unter 200 nm.

Der Rahmen kann zusätzlich seitliche Kanäle enthalten, durch die überschüssiges Polymermaterial beim Preßvorgang herausfließen kann.

Die Länge des Preßstempels kann beispielsweise zwischen 50 und 150 mm, vorzugsweise 80 bis 125 mm betragen, die Breite des Preßstempels (1) zwischen 20 und 150 mm, vorzugsweise 30 bis 125 mm.

Die Innenmaße des Rahmens (2) sind denen des Preßstempels (1) angepaßt und jeweils um 10 bis 100 $\mu$m größer, damit ein einfaches Zusammenfügen und Lösen der beiden Werkzeuge Stempel und Rahmen möglich ist.

Als elektrisch leitfähige Träger = Grundplatte (5) können Metallplatten, z.B. aus Kupfer, Aluminium, Stahl, z.B. mit den Abmessungen 70 bis 150 x 50 bis 150 x 2 bis 15 mm$^3$, vorzugsweise mit den Abmessungen 100 bis 125 x 70 bis 125 x 8 mm$^3$ verwendet werden. Vorzugsweise werden Kupferplatten mit speziell für das jeweils verwendete Polymer adaptierte, elektrisch leitfähige Haftschichten mit Schichtdicken zwischen 1 und 10 $\mu$m, vorzugsweise zwischen 3,5 und 6 $\mu$m verwendet.

Ganz besonders bevorzugt werden elektrisch leitfähige Haftschichten aus oberflächlich oxidiertem Titan verwendet.

Als Polymere können im Prinzip alle bekannten amorphen oder teilkristallinen Thermoplaste verwendet werden, insbesondere amorphe oder teilkristalline Thermoplaste mit Glastemperaturen von 50 bis 200 °C, beispielsweise amorphe Thermoplaste mit Erweichungstemperaturen größer 120 °C oder teilkristalline Thermoplaste mit Schmelztemperaturen über 120 °C.

Bevorzugt verwendet werden Polymethylmethacrylat als Granulat mit einem mittleren Molekulargewicht ($\overline{M}_w$) von 100.000 bis 400.000, sowie teilkristalline Polymere mit Schmelztemperaturen von 140 bis 240°C, z.B. Polyoxymethylene (vgl. z.B. DE-A-41 07 662), Polyalkensulfone (vgl. z.B. DE-A-41 07 851) und aliphatische Polyester (vgl. z.B. DE-A-41 41 352).

Der Preßvorgang wird bei Temperaturen zwischen 100 und 350°C, vorzugsweise bei Temperaturen zwischen 180 und 240°C durchgeführt.

a) Vor Einwirkung des Druckes wird das Polymer in fester Form in den Rahmen, welcher sich auf der Grundplatte befindet, eingefüllt. Vorzugsweise wird ein Überschuß des Polymers eingesetzt. Der Überschuß ist von der Geometrie des Stempels und des Rahmens, sowie von der Art des eingesetzten Polymers abhängig.

b) das Werkzeugoberteil mit dem Preßstempel (1) wird auf dem auf der Grundplatte (5) fixierten Rahmen (2) aufgesetzt und in die auf 150 bis 350°C vorgeheizte Presse gegeben. Die Presse wird anschließend so weit zugefahren, daß die Bolzen des Werkzeugoberteils den Rahmen fest auf die Grundplatte aufdrücken. Der Preßstempel hat hierbei noch keinen Kontakt mit dem Polymer.

c) Nach einer Haltezeit von ca. 1 bis 10 Minuten wird der Preßstempel innerhalb von ca. 1 bis 10 min mit einem Druck von 20 bis 400 bar auf das Polymer (6) gepreßt. Die Haltezeit und der Druck ist von der Art des eingesetzten Polymers abhängig.

d) Die Abkühlzeit auf 20 bis 30°C beträgt 10 bis 40 min.

Die nach dem oben beschriebenen Verfahren aufgebrachten Polymeren (Resiste) besitzen Schichtdicken vorzugsweise zwischen 40 und 650 $\mu$m. Die Oberflächenrauhigkeit beträgt unter 200 nm. Die Gesamtabweichung der Schichtdicke über die gesamte Resistfläche beträgt unter 10 $\mu$m.

Nach der Bestrahlung mit Synchrotronstrahlung durch spezielle Röntgenmasken und der Entwicklung der Polymeren in Form der beschriebenen Polymer-Träger-Verbunde erhält man die Mikrostrukturen in der gewünschten Präzision.

Da sich die strukturierten Polymeren auf einer elektrisch leitfähigen Grundplatte befinden, können nun die im LIGA-Verfahren üblichen Folgeschritte Galvanoformung und Abformung durchgeführt werden.

Beispiel

1,041 g eines Polymethylmethacrylat-Granulats mit einem mittleren Molekulargewicht ($\overline{M}_w$ von 300.000 wurde in einem Preßwerkzeug mit einem Rahmen (2) (siehe Fig. 1 und 2) mit den Innenmaßen 80,030 x 30,030 mm$^2$ und einer Höhe von 10,350 mm auf eine 8 mm dicke Kupferplatte gegeben, die mit ca. 6 $\mu$m Titan beschichtet war,

welches anschließend oberflächlich mit einer Mischung aus Wasserstoffperoxid und Natronlauge oxidiert wurde. Der Preßstempel (1) hat in diesem Falle die Abmessungen 80,000 x 30,000 x 10,000 mm.

Das Werkzeugoberteil mit dem Preßstempel wurde auf den auf der Grundplatte fixierten Rahmen aufgesetzt und in die auf 150 bis 350°C vorgeheizte Presse gegeben. Die Presse wurde anschließend so weit zugefahren, daß die Bolzen des Werkzeugoberteils den Rahmen fest auf die Grundplatte aufdrückten. Der Preßstempel hatte hierbei noch keinen Kontakt mit dem Polymer.

Nach einer Haltezeit von 1 min wurde der Preßstempel 4 min mit einem Druck von 100 bar bei 210°C auf das Polymer gepreßt. Anschließend wurde innerhalb von 30 min auf 25°C abgekühlt.

Nach der Entformung betrug die Schichtdicke des Polymers 350 ± 10 $\mu$m. Die Oberflächenrauhigkeit betrug unter 200 nm.

Nach Synchrotronbestrahlung durch eine spezielle Röntgenmaske und nach der Entwicklung mit dem adaptierten Entwickler (GG-Entwickler, siehe DE 30 39 110 C2) erhielt man Mikrostrukturen aus Polymethylmethacrylat, z.B. Säulen mit einem Durchmesser von 45 $\mu$m, welche sich auf einer leitfähigen Schicht aus Titan befanden.

Anschließend konnten die im LIGA-Verfahren üblichen Folgeschritte Galvanoformung und Abformung durchgeführt werden.

**Patentansprüche**

1. Verfahren zur Herstellung von Mikrostrukturkörpern mit Strukturtiefen von mehreren $\mu$m bis in den mm-Bereich durch bildmäßiges Bestrahlen von Polymeren mit Röntgenstrahlen und Entfernen der bildmäßig bestrahlten Bereiche der Polymeren, dadurch gekennzeichnet, daß die Polymeren vor dem bildmäßigen Bestrahlen in Schichtdicken von mehreren $\mu$m bis in den mm-Bereich durch Aufschmelzen in einem Rahmen unter Druck mit einem Preßstempel auf einen elektrisch leitfähigen Träger aufgebracht und fest verankert werden.

2. Verfahren nach Anspruch 1, dadurch gekennzeichnet, daß als Polymere amorphe Thermoplaste eingesetzt werden, die während des Preßverfahrens aufgeschmolzen werden.

3. Verfahren nach Anspruch 1, dadurch gekennzeichnet, daß als Polymere teilkristalline Thermoplaste eingesetzt werden, die während des Preßverfahrens aufgeschmolzen werden.

4. Verfahren nach einem der vorhergehenden Ansprüche, dadurch gekennzeichnet, daß als Röntgenstrahlen zum bildmäßigen Bestrahlen Synchrotronstrahlung eingesetzt wird.

5. Verfahren nach einem der vorhergehenden Ansprüche, dadurch gekennzeichnet, daß Mikrostrukturkörper mit Strukturtiefen zwischen 3 μm und 2000 μm und kleinsten lateralen Abmessungen von unter 10 μm hergestellt werden.

# FIG.1

FIG.2